# EUROPÄISCHE PATENTSCHRIFT

(11) **EP 2 316 141 B1**
(45) Veröffentlichungstag und Bekanntmachung des Hinweises auf die Patenterteilung: **10.12.2014**
(21) Anmeldenummer: 09741196.1
(22) Anmeldetag: 19.08.2009
(51) Int. Cl.: H01L 41/047, H01L 41/193

(54) **AKTORELEMENT SOWIE SEINE VERWENDUNG**
ACTUATOR ELEMENT AND USE THEREOF
ÉLÉMENT D'ACTIONNEMENT ET SON UTILISATION

(30) Priorität: 20.08.2008 DE 102008039757
(43) Veröffentlichungstag der Anmeldung: 04.05.2011
(73) Patentinhaber: Fraunhofer-Gesellschaft zur Förderung der angewandten Forschung e.V., 80686 München (DE)
(72) Erfinder: JOST, Oliver, 01099 Dresden (DE)
(74) Vertreter: Pfenning, Meinig & Partner GbR
(86) Internationale Anmeldenummer: PCT/DE2009/001198
(87) Internationale Veröffentlichungsnummer: WO 2010/020242

(56) Entgegenhaltungen:
- WO-A1-99/17929
- WO-A1-2007/029275
- WO-A2-01/06579
- WO-A2-2006/123317
- US-A1- 2002 050 454
- T. SEKITANI ET AL.: "A Rubberlike Stretchable Active Matrix Using Elastic Consuctors" SCIENCE AMERICAN ASSOCIATION FOR THE ADVANCEMENT OF SCIENCE USA, Bd. 321, Nr. 5895, 7. August 2008 (2008-08-07), Seiten 1468-1472, XP002565787 ISSN: 0036-8075 in der Anmeldung erwähnt

## Beschreibung

Die Erfindung betrifft Aktorelemente sowie deren Verwendung, die für mechatronische, adaptive Applikationen unter unterschiedlichsten Einsatzbedingungen eingesetzt werden können. Dabei können mit den erfindungsgemäßen Aktorelementen deren Veränderungen der Form und Größe ausgenutzt werden, um beispielsweise Bewegungen zu initiieren oder eine Kraftwirkung auszuüben. Sie können u.a. analog zu Piezoelementen eingesetzt werden.

Piezoelemente sind aber wegen deren mechanischen Eigenschaften und der begrenzten Dehnbarkeit häufig nicht oder nur unzulänglich einsetzbar. Auch die Herstellungskosten können zu hoch sein.

So sind in der Vergangenheit Versuche unternommen worden Aktoren mit dielektrischen elastomeren Kunststoffen zur Verfügung zu stellen. Dabei gibt es aber aufgrund der hohen Dehnungen Probleme bei der elektrischen Kontaktierung und Verbindung der erforderlichen Elektroden, die unter allen Einsatzbedingungen gegeben sein soll.

Die erforderlichen Schaltspannungen liegen in einem Bereich von 100 kV, die häufig nicht beherrsch- oder einsetzbar sind.

Auch unterscheiden sich die Eigenschaften des Werkstoffs für den dielektrischen Teil und die Elektroden in vielen Punkten gravierend, was sich besonders ungünstig bei sich veränderten Einsatz- bzw. Umgebungsbedingungen auswirkt.

Üblicherweise werden Metallelektroden eingesetzt, die jedoch völlig andere mechanische Eigenschaften aufweisen, als die relativ weichen Elastomere. Die Funktionalität solcher Aktoren leidet daher meist unter dem Versagen der Elektroden.

Bei hochdehnbaren Elastomeren sollen Elektroden ein ähnliches Dehnungsverhalten aufweisen. Daher werden Elektroden mit elektrisch leitfähigen Graphitflocken hergestellt, die mit einem Siliconöl auf polymere Oberflächen aufgetragen werden. Dabei wird aber ein eigentlich trockener "Aktor" mit einer teilweise flüssigen Schicht beaufschlagt wird. Dies ist aber bei einem Stapelaufbau mit einem Wechsel von Elektroden und Polymerschichten sehr ungünstig. So ausgebildete Elektroden sind sehr gleitfähig und stellen daher mechanische Schwachpunkte dar. Außerdem ist die optische Transparenz erheblich beeinträchtigt.

Für die Ausbildung von optisch transparenten Elektroden, die beispielsweise bei organischen Leuchtdioden (OLED's) genutzt werden können, ist es bekannt Kohlenstoff-Nanoröhrchen (CNT) in einer Dispersion aufzutragen und zu trocken, so dass sie schichtförmig auf den leuchtenden organischen Schichten ausgebildet und dabei auch elektrisch leitend sind. Die CNT's sind dabei in einer organischen Matrix mit einem relativ hohen Anteil enthalten, wobei ein Kompromiss zwischen elektrischer Leitfähigkeit und optischer Transparenz bzgl. des jeweiligen Anteils an CNT's und der Elektrodendicke gemacht werden muss.

Die so hergestellten Elektroden haben ebenfalls stark abweichende Eigenschaften von den anderen Komponenten solcher OLED's.

Von T. Sekitani u.a. ist es aus "A Rubberlike Stretchable Active Matrix Using Elastic Conductors" Science Express Online 7.08.2008 bekannt elektrisch leitfähige flexible Elemente aus Kunststoff herzustellen, die elektrisch leitend sind und gleichzeitg gedehnt werden können. Dabei sollen CNT's in flüssiges Vinylidenfluoridhexafluoropropylen mit einem Zusatz von ionischem 1-Butyl-3-Methylimidazoliumbisimid gegeben und die so erhaltene Mischung soll dann auf einen Glasträger aufgetragen wird. Das erhaltene Kompositmaterial konnte dann mit dehnbarem Silikongummi verbunden werden. Mit einem hohen Anteil von 20 Masse.-% an CNT's kann die elektrische Leitfähigkeit erhöht werden. Der elektrisch leitende Teil mit den CNT's und der Silikongummi weisen aber auch wieder voneinander abweichende Eigenschaften auf und bilden einen Materialverbund unterschiedlicher Werkstoffe mit unterschiedlichen mechanischen Eigenschaften, wodurch solche Aktorelemente eine verkürzte Lebensdauer oder verschlechterte Eigenschaften aufweisen.

Aus WO 01/06579 A2 ist ein elektroaktives Polymer bekannt, mit dem eine Übertragung elektrischer in mechanische Energie möglich ist. Dabei soll jeweils eine elektrisch leitende Elektrode von einer dielektrischen Trennschicht eingefasst sein. Außerdem ist es auch bekannt Kohlenstoffnanoröhrchen als Elektrodenmaterial und ein elektrisch leitfähiges Polymer einzusetzen.

Es ist daher Aufgabe der Erfindung Aktorelemente zur Verfügung zu stellen, die verbesserte Eigenschaften aufweisen und kostengünstig herstellbar sind.

Erfindungsgemäß wird diese Aufgabe mit einem Aktorelement, das die Merkmale des Anspruchs 1 aufweist, gelöst. Verwendungen sind im Anspruch 15 angegeben. Vorteilhafte Ausgestaltungen und Weiterbildungen können mit in untergeordneten Ansprüchen bezeichneten Merkmalen erreicht werden.

Die erfindungsgemäßen Aktorelemente sind mit mindestens einer dielektrischen Trennschicht, die von zwei elektrisch leitenden Elektroden eingefasst ist, gebildet. Elektroden und Trennschicht sind dabei mit dem gleichen entropie-elastisch (gummielastisch) verformbaren Kunststoff gebildet. Solche geeigneten Kunststoffe kann man auch als Elastomere oder thermoplastische Elastomere bezeichnen. Zumindest in den Elektroden bildet der Kunststoff eine Matrix in der Kohlenstoff-Nanoröhrchen eingebettet sind. Der Anteil an Kohlenstoff-Nanoröhrchen soll im Bereich 0,001 bis 30 Masse-%, bevorzugt bis 1 Masse-% gehalten sein.

Vorteilhaft wirken sich ein großes Verhältnis Länge zu Außendurchmesser und der Einsatz einwandiger Kohlenstoff-Nanoröhrchen (SWCNT's) aus. Das Verhältnis von Länge zu Außendurchmesser sollte mindestens 8 : 1, bevorzugt 100 : 1 gewählt sein. Der maximale Außendurchmesser sollte 100 nm nicht überschreiten.

Dielektrische Trennschichten sollten eine Schichtdicke im Bereich 100 nm bis 5 mm und Elektroden Schichtdicken im Bereich 100 nm bis 5 mm aufweisen.

Es können elastisch verformbare Kunststoffe eingesetzt werden, die eine Dehnung um mindestens 5 % bis zum Erreichen der Bruchgrenze bei Einsatztemperatur zulassen. Unter entropie-elastisch verformbaren Kunststoffen sollen dabei solche verstanden werden, deren Glasübergangspunkt unterhalb einer Einsatztemperatur liegt, wobei diese Temperatur in der Regel die Raumtemperatur sein soll, so dass die Glasübergangstemperatur dann unterhalb 0 ° C liegen sollte.

Besonders vorteilhaft bei den erfindungsgemäßen Aktorelementen ist es, dass sie im Wesentlichen aus dem gleichen Werkstoff gebildet sind und keine Grenz oder Barriereschichten Elektroden und Trennschicht voneinander trennen, so dass sie unmittelbar ineinander übergehen. Die zumindest in den Elektroden enthaltenen Kohlenstoff-Nanoröhrchen verändern die Werkstoffeigenschaften, wenn überhaupt nur unwesentlich. Es wird lediglich die elektrische Leitfähigkeit um Gröβenordnungen erhöht.

Kohlenstoff-Nanoröhrchen können auch mit kleinerem Anteil als in den Elektroden in der dielektrischen Trennschicht eingebettet sein, wodurch die Eigenschaften weiter angeglichen werden können. Dabei sollte die Perkolationsschwelle nicht überschritten werden.

Durch die kleinen erforderlichen Anteile an eingebetteten Kohlenstoff-Nanoröhrchen kann bei geeignet ausgewähltem Kunststoff auch optische Transparenz bzw. Transluzenz zumindest in einem Teilbereich des Wellenlängenspektrums des sichtbaren Lichts erreicht werden. Die Transparenz sollte dabei mindestens 50 % betragen. Optisch transparente Aktorelemente können als optische Elemente genutzt werden, bei denen die Brechzahl und/oder die Brennweite verändert werden kann.

Besonders vorteilhaft ist es, Aktorelemente als Schichtstapel auszubilden, bei denen mehr als zwei Elektroden und eine dielektrische Trennschicht vorhanden sind. Ein solcher Schichtstapel kann in ein an mindestens einer Stirnseite offenes Gehäuseelement, beispielsweise einen Hohlzylinder eingesetzt sein. Dadurch kann eine Verformung in lediglich einer Achsrichtung ausgenutzt werden. An der Innenwand des Gehäuseelements können dann elektrische Anschlüsse für die elektrische Kontaktierung der Elektroden vorhanden sein. Ein Aktorelelement kann dabei so in ein Gehäuseelement eingepasst eingesetzt sein, dass eine Kraft auf den elastomeren Kunststoff wirkt, das Aktorelement dadurch zusammengedrückt und vorgespannt ist.

Ein Aktorelement kann aber auch als spiralförmige Wicklung von miteinander verbundenen Elektroden mit dielektrischer Trennschicht ausgebildet sein. Das so gebildete Aktorelement hat die Form eines Zylinders. Es kann Druckkräfte in Richtung der Zylinderachse ausüben.

Es kann außerdem günstig sein, Kohlenstoff-Nanoröhrchen mit funktionalisierter Oberfläche einzusetzen. Dabei können Dotierungen gewählt werden, die die elektrische Leitfähigkeit erhöhen. Hierfür können geeignete Metallelemente und Metallionen eingesetzt werden. Es besteht aber auch die Möglichkeit sie chemisch zu funktionalisieren, um verbesserte Oberflächeneigenschaften bzgl. der Benetzbarkeit mit dem jeweiligen Kunststoff zu erreichen, so dass die Einbettung in die Kunststoffmatrix vor dem Auspolymerisieren bzw. Vernetzen erleichtert ist.

Beispiele für geeignete Kunststoffe sind: Polyurethane, Polyacrylate oder Silicone (z.B. Siliconkautschuk oder Siliconharze).

Es können auch Polymergemische also so genannte Polyblends eingesetzt werden, mit denen eine weitergehende Anpassung an für die jeweilige Applikation gewünschte Eigenschaften vorgenommen werden kann. Es besteht auch die Möglichkeit Kunststoffe einzusetzen, mit denen auch viskoelastische Verformungen erreicht werden können, die auch relaxierbar sein können.

Unter Nutzung des prinzipiellen Wirkprinzips kann ein Aktorelement aber auch als Sensorelement oder als Kombination Aktor/Sensor genutzt werden, um beispielsweise Kräfte oder Drücke zu bestimmen und/oder solche Wirkungen auszuüben.

Mit erfindungsgemäßen Aktorelementen sind aber auch eine Dämpfung und auch die Anregung von Schwingungen möglich. Dabei kann eine Schalldämpfung, auch von Körperschall erreicht werden. Auch ein Einsatz in der Akustik ist möglich.

Neben der Ausnutzung einer veränderbaren Haptik können Aktorelemente auch in der Medizintechnik (Bionik), beispielsweise als künstliche Muskeln eingesetzt werden.

Mit einer gezielten Auswahl von Kohlenstoff-Nanoröhrchen bzgl. ihres Längen - Außendurchmesserverhältnisses kann Einfluss auf die elektrischen Eigenschaften genommen werden. Dies betrifft auch die Frequenz bei der die relative Permittivität der dielektrischen Trennschicht maximal wird. Es kann aber auch die Breite des Frequenzintervalls in dem die relative Permittivität maximal gehalten werden kann, beeinflusst werden. Dabei kann mit dünneren und längeren Kohlenstoff-Nanoröhrchen eine kleinere Frequenz, als mit dickeren und kürzeren erreicht werden. Die Breite der Verteilung der Außendurchmesser von Kohlenstoff-Nanoröhrchen, die eingebettet sind, beeinflusst die Breite des Frequenzintervalls in dem die relative Permittivität maximal sein kann. Eine schmale Außendurchmesserverteilung führt zu einem kleineren Frequenzintervall als eine breitere Außendurchmesserverteilung.

Erfindungsgemäße Aktorelemente können beispielsweise so hergestellt werden, dass Kohlenstoff-Nanoröhrchen im jeweiligen Kunststoff bei geeigneter Viskosität dispergiert werden. Dabei kann ein für den Kunststoff geeignetes Lösungsmittel eingesetzt sein. Mit dem Kunststoff, in dem ggf. ein kleiner Anteil an Kohlenstoff-Nanoröhrchen enthalten ist, kann eine Folie für dielektrische Trennschichten und weiter für Folien mit höheren Anteilen an Kohlenstoff-Nanoröhrchen hergestellt werden. Diese Folien können dann miteinander verbunden werden, bevor eine Polymerisation, Polykondensation bzw. Vernetzung erfolgt ist. Es kann so ein Aktorelement als ein einheitlicher polymerer Körper erhalten werden.

Es besteht aber auch die Möglichkeit die Oberfläche solcher Folien zu Funktionalisieren und dann Folien für Elektroden und dielektrische Trennschichten unter Druckkraftbeaufschlagung miteinander zu fügen, so dass ein fester Verbund Trennschicht und Elektroden erreicht werden kann. Für die Oberflächenfunktionalisierung kann beispielsweise ein Lösungsmittel für den jeweiligen Kunststoff aufgetragen und die Oberfläche angelöst werden.

Die erfindungsgemäßen Aktorelemente können im Idealfall auch in einem Vollpolymerprozess und daher auch sehr kostengünstig hergestellt werden. Zumindest die mechanischen und im Wesentlichen auch die thermischen Eigenschaften der Elektroden und Trennschichten sind zumindest nahezu gleich. Dadurch kann auch die Lebensdauer positiv beeinflusst werden.

Durch den Einsatz der dünnen und langen Kohlenstoff-Nanoröhrchen in Trennschichten kann der effektive Abstand zwischen Elektroden bedingt durch die Ausbildung unvollständiger elektrischer Leitpfade zwischen den Elektroden verkleinert werden, wodurch die erforderliche elektrische Spannung erheblich reduziert werden kann. Je nach Einsatzfall und Frequenz kann dadurch auch eine Anwendung unter biokompatiblen Bedingungen, wie z.B. in der Medizintechnik oder Biometrie, möglich sein.

Auch die an sich bekannten mit Kohlenstoff-Nanoröhrchen erreichbaren Selbstheilungseffekte beim Betrieb und der Einwirkung von Zug- und Druckspannungen auf Aktorelemente können ausgenutzt werden, da aufgetretene Durchschlagskanäle durch viskoplastische Anteile des elastomeren Kunststoffs geschlossen werden können. Mit einer gleichartigen und engen Verzahnung der Nanoröhrchen in Elektroden und ggf. Trennschicht in Kombination mit dem gleichen Kunststoffmatrixwerkstoff werden Grenzschichteffekte zwischen Elektroden und Trennschicht vermieden bzw. in ihrer Wirkung stark reduziert.

Durch geeignete Auswahl des jeweiligen Kunststoffs können dessen Eigenschaften, z.B. der E-Modul an den jeweiligen Anwendungsfall angepasst werden. Die Aktorelemente können in der geeigneten Größe und auch geometrischen Gestaltung zur Verfügung gestellt werden.

Im Vergleich zu Piezoaktoren können deutlich größere Stellwege oder Verformungen erreicht werden. Auch der Energiebedarf für den Betrieb ist klein, da kein ständiger elektrischer Stromfluss erforderlich ist. Zum Betreiben ist auch ein kleiner elektrischer Strom erforderlich, so dass auch entsprechend kleine Wärmeverluste erreichbar sind.

Nachfolgend soll die Erfindung beispielhaft näher erläutert werden.

Dabei zeigen:
Figur 1 in schematischer Form einen Schnitt durch ein Beispiel eines erfindungsgemäßen Aktorelements und
Figur 2 eine Möglichkeit zur Herstellung von Aktorelementen.

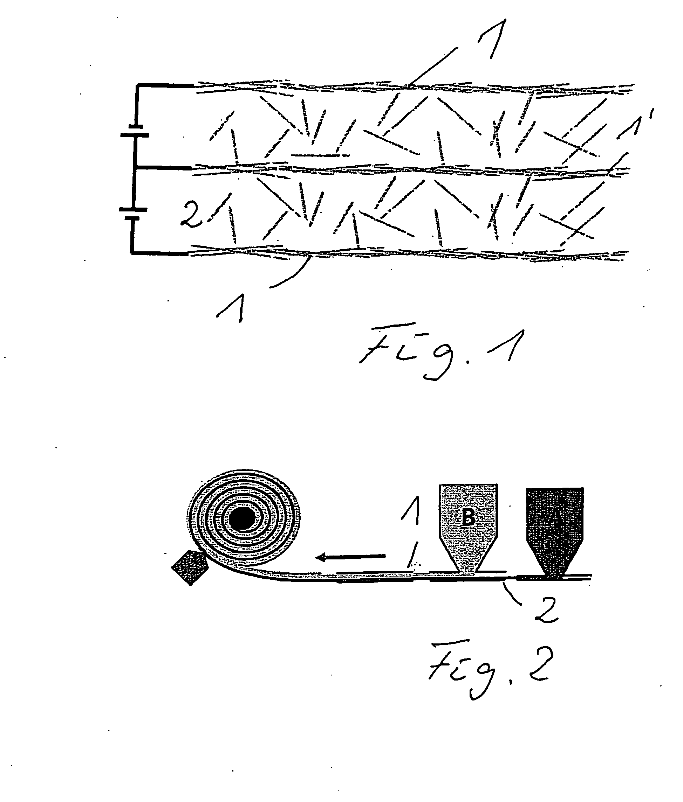

Mit Figur 1 soll ein Aufbau eines Beispiels eines Aktorelements gezeigt werden, bei dem zwei Elektroden 1 und 1', die an unterschiedliche Pole einer elektrischen Spannungsquelle angeschlossen sind, eine dielektrische Trennschicht 2 einfassen. Es wird dabei deutlich, dass Kohlenstoff-Nanoröhrchen sowohl in den Elektroden 1 und 1', wie auch in den beiden Trennschichten 2 in der Kunststoffmatrix eingebettet sind. Der Anteil pro Volumeneinheit an Kohlenstoff-Nanoröhrchen ist in den Elektroden 1 und 1' deutlich höher und erreicht darin 0,5 Masse-%. Die Perkolationsschwelle ist daher in den Elektroden 1 und 1' überschritten. Im Bereich der Trennschichten 2 ist deren Anteil kleiner und liegt hier bei 0,05 Masse-%, so dass die Perkolationsschwelle nicht überschritten ist. Mit diesem Beispiel kann auch darauf hingewiesen werden, dass Schichtstapel mit einer größeren Anzahl an Elektroden 1 und 1' und Trennschichten 2 herstellbar sind. Die Elektroden 1 und 1' bilden mit der zwischen ihnen angeordneten Trennschicht 2 einen elektrischen Kondensator.

Mit Figur 2 soll eine Möglichkeit zur Herstellung von Aktorelementen angesprochen werden. Dabei wird hier eine Folie B für eine Elektrode 1 auf eine Folie A für eine dielektrische Trennschicht 2 aufgebracht. Dabei weisen die Folien A und B zumindest an der zu verbindenden Oberfläche noch eine ausreichende Viskosität auf, mit der eine Verbindung beider Folien A und B möglich ist. Nachfolgend kann der Folienverbund aufgerollt werden. Davor oder nach dem Aufrollen kann eine vollständige Polymerisation, Polykondensation, eine Aushärtung, eine Vernetzung oder Abdampfung von Lösungsmittel, unter Berücksichtigung des Kunststoffs mit dem Elektrode 1 und Trennschicht 2 gebildet sind, durchgeführt und dadurch ein dauerhafter fester Verbund erreicht werden. Für die Herstellung eines Aktorelements kann in nicht dargestellter Form eine zweite Elektrode 1' analog zur Elektrode 1 auf der gegenüberliegenden Seite der Trennschicht 2 mit dieser verbunden werden.

## Patentansprüche

1. Aktorelement bei dem mindestens eine dielektrische Trennschicht (2) an beiden Oberflächen von jeweils einer elektrisch leitenden Elektrode (1, 1') eingefasst ist, dabei die Trennschicht (2) und die Elektroden (1, 1') mit einer bei Einsatztemperatur jeweils gleichen entropie-elastisch verformbaren Kunststoffmatrix gebildet sind und mindestens im die Elektroden (1, 1') bildenden Kunststoff Kohlenstoff-Nanoröhrchen eingebettet sind.

2. Aktorelement nach Anspruch 1, **dadurch gekennzeichnet, dass** der Anteil an in der Kunststoffmatrix eingebetteten Kohlenstoff-Nanoröhrchen von Elektroden im Bereich 0,01 bis 30 Masse-% gehalten ist.

3. Aktorelement nach einem der vorhergehenden Ansprüche, **dadurch gekennzeichnet, dass** Kohlenstoff-Nanoröhrchen mit einem Verhältnis von Länge zu Außendurchmesser von mindestens 8 : 1 eingebettet sind.

4. Aktorelement nach einem der vorhergehenden Ansprüche, **dadurch gekennzeichnet, dass** der eingesetzte Kunststoff bei Einsatztemperatur eine Dehnbarkeit bis zum Erreichen der Bruchgrenze von mindestens 5 % aufweist.

5. Aktorelement nach einem der vorhergehenden Ansprüche, **dadurch gekennzeichnet, dass** Kohlenstoff-Nanoröhrchen mit einem maximalen Außendurchmesser von 100 nm eingesetzt sind.

6. Aktorelement nach einem der vorhergehenden Ansprüche, **dadurch gekennzeichnet, dass** Elektroden (1, 1') und Trennschicht (2) unmittelbar ineinander übergehen.

7. Aktorelement nach einem der vorhergehenden Ansprüche, **dadurch gekennzeichnet, dass** eine Mehrzahl von Aktorelementen einen Schichtstapel bilden.

8. Aktorelement nach einem der vorhergehenden Ansprüche, **dadurch gekennzeichnet, dass** in der Trennschicht (2) Kohlenstoff-Nanoröhrchen mit einem kleineren Anteil als in den Elektroden (1, 1') enthalten sind.

9. Aktorelement nach einem der vorhergehenden Ansprüche, **dadurch gekennzeichnet, dass** es zumindest in einem Teilbereich des Wellenlängenbereichs von sichtbarem Licht eine Transparenz von mindestens 50 % aufweist.

10. Aktorelement nach einem der vorhergehenden Ansprüche, **dadurch gekennzeichnet, dass** Kohlenstoff-Nanoröhrchen mit definiertem Längen - Außendurchmesserverhältnis und/oder -verteilung zur gezielten Beeinflussung der Frequenz, bei der die relative Permittivität der dielektrischen Trennschicht maximal und/oder der Breite des Frequenzintervalls in dem dies erreichbar ist.

11. Aktorelement nach einem der vorhergehenden Ansprüche, **dadurch gekennzeichnet, dass** die dielektrische Trennschicht (2) ein Schichtdicke im Bereich 100 nm bis 5 mm und die Elektroden (1, 1') eine Schichtdicke im Bereich 100 nm bis 5 mm aufweisen.

12. Aktorelement nach einem der vorhergehenden Ansprüche, **dadurch gekennzeichnet, dass** ein Schichtstapel mit übereinander angeordneten Elektroden (1, 1') und Trennschichten (2) innerhalb eines an Stirnseiten offenen Gehäuseelements angeordnet und an der Innenwand des Gehäuseelements elektrische Anschlüsse für die Kontaktierung von Elektroden (1, 1') vorhanden sind.

13. Aktorelement nach einem der vorhergehenden Ansprüche, **dadurch gekennzeichnet, dass** Kohlenstoff-Nanoröhrchen, die an ihrer Oberfläche funktionalisiert sind, eingesetzt sind.

14. Aktorelement nach einem der vorhergehenden Ansprüche, **dadurch gekennzeichnet, dass** die entropie-elastisch verformbare Kunststoffmatrix für Trennschicht (2) und Elektroden (1, 1') aus einem Polyurethan, einem Polyacrylat oder einem Silicon gebildet ist.

15. Verwendung eines Aktorelements nach einem der vorhergehenden Ansprüche, als Sensorelement, Aktor-/Sensorlement, optisches Element, Schwingungen dämpfendes und/oder erregendes Element.

## Claims

1. An actuator element in which at least one dielectric separation layer (2) is encompassed on both surfaces by one electrically conductive electrode (1, 1') in each case, the separation layer (2) and the electrodes (1, 1') are formed with an entropy-elastically deformable plastics-material matrix which is identical in each case at use temperature, and carbon nanotubes are embedded at least in the plastics material forming the electrodes (1, 1').

2. An actuator element according to Claim 1, **characterised in that** the proportion of carbon nanotubes embedded in the plastics-material matrix of electrodes is kept in the range of 0.01 to 30 mass %.

3. An actuator element according to one of the preceding claims, **characterised in that** carbon nanotubes with a ratio of length to external diameter of at least 8:1 are embedded.

4. An actuator element according to one of the preceding claims, **characterised in that** the plastics material used at use temperature has an elongation at break of at least 5%.

5. An actuator element according to one of the preceding claims, **characterised in that** carbon nanotubes with a maximum external diameter of 100 nm.

6. An actuator element according to one of the preceding claims, **characterised in that** the electrodes (1, 1') and separation layer (2) merge directly into one another.

7. An actuator element according to one of the preceding claims, **characterised in that** a plurality of actuator elements form a layered stack.

8. An actuator element according to one of the preceding claims, **characterised in that** carbon nanotubes are contained in the separation layer (2) in a smaller proportion than in the electrodes (1, 1').

9. An actuator element according to one of the preceding claims, **characterised in that** at least in a partial range of the wavelength range of visible light it has a transparency of at least 50%.

10. An actuator element according to one of the preceding claims, **characterised in that** carbon nanotubes with a defined ratio and/or distribution of length to external diameter for specifically influencing the frequency at which the relative permittivity of the dielectric separation layer is at a maximum and/or the width of the frequency interval in which this can be achieved.

11. An actuator element according to one of the preceding claims, **characterised in that** the dielectric separation layer (2) has a layer thickness in the range of 100 nm to 5 mm and the electrodes (1, 1') have a layer thickness in the range of 100 nm to 5 mm.

12. An actuator element according to one of the preceding claims, **characterised in that** a layered stack with electrodes (1, 1') and separation layers (2) arranged one above the other is arranged inside a housing element which is open on end faces, and electrical connectors for contacting electrodes (1, 1') are present on the inner wall of the housing element.

13. An actuator element according to one of the preceding claims, **characterised in that** carbon nanotubes which are functionalised on their surface are used.

14. An actuator element according to one of the preceding claims, **characterised in that** the entropy-elastically deformable plastics-material matrix for the separation layer (2) and electrodes (1, 1') is formed from a polyurethane, a polyacrylate or a silicone.

15. Use of an actuator element according to one of the preceding claims as a sensor element, actuator/sensor element, optical element, vibration-damping and/or vibrationexciting element.

## Revendications

1. Élément d'actionnement, dans lequel au moins une couche de séparation (2) diélectrique est bordée sur les deux surfaces par respectivement une électrode (1, 1') électroconductrice, ladite couche de séparation (2) et lesdites électrodes (1, 1') étant formées respectivement avec une matrice en matière plastique identique, déformable par élasticité entropique à la température d'utilisation, et des nanotubes de carbone étant enrobés au moins dans la matière plastique formant les électrodes (1, 1').

2. Élément d'actionnement selon la revendication 1, **caractérisé en ce que** la proportion de nanotubes de carbone enrobés dans la matrice en matière plastique des électrodes est maintenue dans une plage de 0,01 à 30 % en masse.

3. Élément d'actionnement selon l'une quelconque des revendications précédentes, **caractérisé en ce que** les nanotubes de carbone sont enrobés selon un rapport entre la longueur et le diamètre extérieur d'au moins 8 à 1.

4. Élément d'actionnement selon l'une quelconque des revendications précédentes, **caractérisé en ce que** la matière plastique utilisée possède, à la température d'utilisation, une extensibilité jusqu'à la limite de rupture de 5 % au moins.

5. Élément d'actionnement selon l'une quelconque des revendications précédentes, **caractérisé en ce que** les nanotubes de carbone utilisés ont un diamètre extérieur maximum de 100 nm.

6. Élément d'actionnement selon l'une quelconque des revendications précédentes, **caractérisé en ce que** les électrodes (1, 1') et la couche de séparation (2) se fondent directement l'une dans l'autre.

7. Élément d'actionnement selon l'une quelconque des revendications précédentes, **caractérisé en ce qu'**une pluralité d'éléments d'actionnement forment un empilement de couches.

8. Élément d'actionnement selon l'une quelconque des revendications précédentes, **caractérisé en ce que** les nanotubes de carbone sont contenus dans la couche de séparation (2) dans une proportion plus faible que dans les électrodes (1, 1').

9. Élément d'actionnement selon l'une quelconque des revendications précédentes, **caractérisé en ce qu'**au moins dans une zone partielle de la plage de longueur d'ondes de la lumière visible, ledit élément d'actionnement possède une transparence d'au moins 50 %.

10. Élément d'actionnement selon l'une quelconque des revendications précédentes, **caractérisé en ce que** des nanotubes de carbone ayant un rapport défini et/ou une distribution définie entre la longueur et le diamètre extérieur sont utilisés pour influer de manière ciblée sur la fréquence à laquelle la permittivité relative de la couche de séparation diélectrique est maximale et/ou sur la largeur de l'intervalle de fréquence dans lequel cela peut être obtenu.

11. Élément d'actionnement selon l'une quelconque des revendications précédentes, **caractérisé en ce que** la couche de séparation (2) diélectrique a une épaisseur comprise dans la plage allant de 100 nm à 5 mm et les électrodes (1, 1') ont une épaisseur comprise dans la plage allant de 100 nm à 5 mm.

12. Élément d'actionnement selon l'une quelconque des revendications précédentes, **caractérisé en ce qu'**un empilement de couches avec des électrodes (1, 1') et des couches de séparation (2), disposées les unes au-dessus des autres, est disposé à l'intérieur d'un boîtier ouvert sur les faces frontales, et des raccords électriques pour la mise en contact des électrodes (1, 1') sont disponibles sur la paroi intérieure du boîtier.

13. Elément d'actionnement selon l'une quelconque des revendications précédentes, **caractérisé en ce que** l'on utilise des nanotubes de carbone qui sont fonctionnalisés au niveau de leur surface.

14. Élément d'actionnement selon l'une quelconque des revendications précédentes, **caractérisé en ce que** la matrice en matière plastique, déformable par élasticité entropique, pour la couche de séparation (2) et les électrodes (1, 1') est constituée de polyuréthanne, de polyacrylate ou de silicone.

15. Utilisation d'un élément d'actionnement selon l'une quelconque des revendications précédentes, sous la forme d'un élément capteur, d'un élément actionneur/capteur, d'un élément optique, d'un élément amortissant et/ou stimulant les vibrations.
